# EUROPEAN PATENT APPLICATION

(11) **EP 4 832 283 A1**
(43) Date of publication of application: **28.10.2026**
(21) Application number: 26173831.4
(22) Date of filing: 21.04.2026
(51) Int. Cl.: H02H 5/10, G01R 31/52

(54) **SYSTEMS AND METHODS FOR GROUND MONITORING**

(30) Priority: 21.04.2025 US 202563792215 P
(71) Applicant: Erico International Corporation, Solon, OH 44139 (US)
(72) Inventor: Frackelton, Brian, Macedonia (US); Hussain, Hasan, Cleveland (US)
(74) Representative: Barker Brettell LLP

(57) **Abstract**

The disclosed technology provides an improved ground monitoring system (100) for an electrical system. The ground monitoring system includes a grounding conductor, a current sensor (108) electrically connected to the grounding conductor, and a processor (112) in communication with the current sensor. The ground monitoring system further includes a memory (118) in communication with the processor and has instructions store thereon. When executed, the instructions cause the processor to measure, via the current sensor, a plurality of current values corresponding to a leakage current on the grounding conductor. Based on the plurality of measured current values, a status of leakage current on the grounding conductor is determined. A first alarm is outputted (225) based upon the status of the leakage current.

## Description

### BACKGROUND

The grounding of electrical systems can be used in different settings to provide a path for electrical current to flow into the earth in the event of a fault. For example, faults may be associated with short circuit events. If an earth ground connection becomes disconnected or intermittent, equipment can be susceptible to damage and electrical failures caused by excess currents.

### SUMMARY

The present disclosure relates to ground connection monitoring technology and, in particular, to improved systems and methods for identifying a disconnection or intermittent connection between an electrical system and earth ground.

According to an aspect of the present disclosure, a ground monitoring system for an electrical system is provided. The ground monitoring system includes a grounding conductor, a current sensor electrically connected to the grounding conductor, a processor in communication with the current sensor, and a memory in communication with the processor and having instructions stored thereon that, when executed, cause the processor to measure, via the current sensor, a plurality of current values corresponding to a leakage current on the grounding conductor. Based on the plurality of measured current values, the processor determines a status of leakage current on the grounding conductor. The processor outputs a first alarm based upon the status of the leakage current.

In some examples, the status of leakage current on the grounding conductor is determined based on a determination of whether noise is present in the plurality of current values.

In some examples, the memory has further instructions stored thereon that, when executed, cause the processor to determine a historical current profile for the electrical system based on historical current values. As part of determining the status of the leakage current, the processor compares the plurality of measured current values to the historical current profile.

In some examples, the memory has further instructions stored thereon that, when executed, cause the processor to identify one or more patterns in the historical current values. The one or more patterns comprise a correlation between a time and an average leakage current.

In some examples, the memory has further instructions stored thereon that, when executed, cause the processor to output a second alarm upon determining there is an intermittent presence of the leakage current on the grounding conductor.

In some examples, the ground monitoring system further includes a surge protection module, wherein the current sensor is arranged within the surge protection module.

In some examples, the memory has further instructions stored thereon that, when executed, cause the processor to receive a plurality of power values of the electrical system corresponding to the plurality of current values. Determining the status of the leakage current comprises comparing the plurality of power values to the plurality of current values.

In some examples, comparing the plurality of power values to the plurality of current values comprises identifying one or more increases in the plurality of current values and determining the status based on determining if the one or more increases are proportional to increased power consumption indicated by the plurality of power values.

According to another aspect of the present disclosure, a method of monitoring a ground connection of an electrical system is provided. The method includes obtaining, via a sensor, a plurality of current values corresponding to a leakage current of a grounding conductor. The method further includes determining a status of leakage current of the grounding conductor based on the plurality of current values. The method further includes outputting a first alarm based upon the status of the leakage current corresponding to a disconnected status or an intermittently connected status of the grounding conductor.

In some examples, the method further includes determining a historical current profile for the electrical system based on historical current values. Determining a status of leakage current of the grounding conductor comprises comparing the plurality of current values to the historical current profile.

In some examples, the method further includes identifying one or more patterns in the plurality of current values and updating the historical current profile based on the one or more patterns.

In some examples, the method further includes receiving a plurality of power values of the electrical system corresponding to the plurality of current values. Determining a status of leakage current of the grounding conductor comprises comparing the plurality of power values to the plurality of current values.

In some examples, comparing the plurality of power values to the plurality of current values comprises identifying one or more increases in the plurality of current values and determining the status based on determining if the one or more increases are proportional to increased power consumption indicated by the plurality of power values.

According to another aspect of the present disclosure, a ground monitoring system for an electrical system is provided. The ground monitoring system includes a grounding conductor, a current sensor electrically connected to the grounding conductor, a processor in communication with the current sensor, and a memory in communication with the processor and having instructions stored thereon that, when executed, cause the processor to measure, via the current sensor, a plurality of current values corresponding to a leakage current on the grounding conductor. The processor receives a plurality of power values of the electrical system corresponding to the plurality of current values. The processor determines a status of leakage current on the grounding conductor based on the plurality of current values and the plurality of power values.

In some examples, the status of leakage current on the grounding conductor is further determined based on a presence of noise in the plurality of current values.

In some examples, the memory has further instructions stored thereon that, when executed, cause the processor to output an alarm based on the status of the leakage current.

In some examples, the memory has further instructions stored thereon that, when executed, cause the processor to output a second alarm upon determining there is an intermittent presence of the leakage current on the grounding conductor.

In some examples, the status of leakage current on the grounding conductor is determined based on the plurality of current values indicating an absence of leakage current on the grounding conductor.

In some examples, determining the status of the leakage current comprises comparing the plurality of power values to the plurality of current values.

In some examples, comparing the plurality of power values to the plurality of current values comprises identifying one or more increases in the plurality of measurement current values and determining the status based on determining if the one or more increases are proportional to increased power consumption indicated by the plurality of power values.

According to another aspect of the present disclosure, a ground monitoring system for an electrical system is provided. The ground monitoring system includes a grounding conductor, a voltage sensor electrically connected to the grounding conductor, a processor in communication with the voltage sensor, and a memory in communication with the processor and having instructions stored thereon that, when executed, cause the processor to measure, via the voltage sensor, a plurality of voltage values corresponding to the grounding conductor. Based on the plurality of measured voltage values, the processor determines a status of a ground connection of the grounding conductor. The processor outputs an alarm based upon the status of the ground connection.

In some examples, the memory has further instructions stored thereon that, when executed, cause the processor to receive a plurality of power values of the electrical system corresponding to the plurality of voltage values. Determining the status of the ground connection comprises comparing the plurality of power values to the plurality of voltage values.

In some examples, the status of the ground connection is determined based on a determination of whether noise is present in the plurality of measured voltage values.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the ground monitoring system or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the invention and, together with the description, serve to explain the principles of examples of the invention.
FIG. 1 is a schematic block diagram of an example system for a ground monitoring system.
FIG. 2 is an example flowchart for monitoring a ground connection of an electrical system.
FIG. 3 shows example test data for monitoring a ground connection of an electrical system.

### DETAILED DESCRIPTION

Before any examples of the disclosed technology are explained in detail, it is to be understood that the disclosed technology is not limited in its application to the details of construction and the arrangement of components set forth in the following description or illustrated in the following drawings. The disclosed technology is capable of other implementations and of being practiced or of being carried out in various ways. Also, it is to be understood that the phraseology and terminology used herein is for the purpose of description and should not be regarded as limiting.

The following discussion is presented to enable a person skilled in the art to make and use examples of the disclosed technology. Various modifications to the illustrated examples will be readily apparent to those skilled in the art, and the generic principles herein can be applied to other examples and applications without departing from the disclosed technology. Thus, the disclosed technology are not intended to be limited to examples shown, but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the disclosed technology. Skilled artisans will recognize the examples provided herein have many useful alternatives that also fall within the scope of the disclosed technology.

As noted above, systems for determining earth ground connections can be used to ensure electrical stability and protection in an electrical system. Generally, the process for checking earth ground connections requires a technician to perform visual or manual inspections at various locations surrounding the earth ground. Examples of the disclosed technology may provide an improved design for ground monitoring technology, including a system which can provide continuous or automated monitoring. In particular, some examples can include arrangements that can provide alerts to a remote device when a disconnect between earth ground and an electrical system is detected.

Generally, systems according to the disclosed technology can include sensors to monitor leakage current through ground connections. In particular, it has been determined that leakage current can provide a useful indicator for grounding connections. Accordingly, by monitoring leakage current at a ground connection (e.g., in comparison to other system parameters), potential disconnects, or other issues can be efficiently identified.

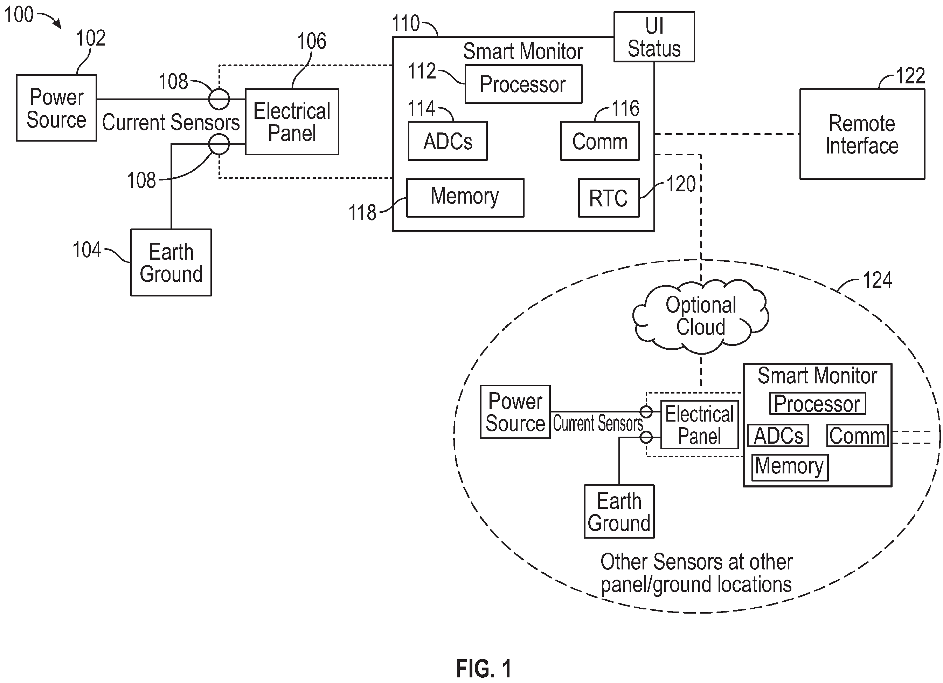

Referring to FIG. 1, an example ground monitoring system 100 that can be used to monitor an earth ground connection is illustrated. In the illustrated example, the monitored system includes a power source 102, an earth ground 104, and an electrical panel 106. The monitoring system 100 includes in particular one or more sensors 108, and a smart monitor 110 (e.g., a programmable controller or other electronic computing device). As illustrated in FIG. 1, the one or more sensors 108 can include one or more current sensors arranged to measure an electrical current value between the power source 102 and the electrical panel 106. Further, one or more of the sensor(s) 108 can be arranged to measure electrical values (e.g., current or voltage) between the earth ground 104 and the electrical panel 106. Moreover, as shown in FIG. 1, the one or more sensors 108 may be connected to the smart monitor 110.

In some examples, the power source 102 may be supplied by a utility company. For example, the power source 102 may be a local power grid, to which the electrical panel 106 is connected via overhead or underground power lines. In further examples, the power source 102 may include one or more solar panels, generators, or the like. The electrical panel 106 may distribute power received from the power source 102 to a connected residential, commercial, or industrial building, facility, or property. In some examples, the electrical panel 106 may be a sub-panel that distributes power to a portion of a connected building, facility, or property.

The earth ground 104 may provide a path for electrical current to flow into the earth in the event of a fault. For example, if components connected to the electrical panel 106 experience a short circuit event, excess current can be directed through the earth ground connection and into the earth ground 104. In some examples, the earth ground 104 may be connected to the electrical panel 106 via a conductor, such as a wire, cable, bus bar, or the like.

In some examples, the earth ground 104 may include one or more grounding electrodes, e.g., ground rods, ground plates, concrete-encased electrodes (e.g., Ufer grounds), or connections to metal water piping systems. The grounding conductor connecting the electrical panel 106 to the earth ground 104 may be a copper or aluminum conductor sized according to the electrical system requirements. In some installations, multiple grounding electrodes may be bonded together to form a grounding electrode system, and the one or more sensors 108 may be positioned to monitor current flow through individual grounding conductors or through a common grounding electrode conductor.

The one or more sensors 108 can include a current sensor or a voltage sensor. As mentioned above, the one or more sensors 108 may be connected to the smart monitor 110. In some examples, the one or more sensors 108 may be hardwired to the smart monitor 110 using a cable or other communication link. In further examples, the one or more sensors 108 may be wirelessly connected to the smart monitor 110 via Bluetooth, wi-fi, or the like. In some examples, one or more sensors 108 and the smart monitor 110 may be a single unit. For example, the one or more sensors 108 and the smart monitor may be embedded into a surge protection device or may be a stand alone device installed at a meter or electrical panel 106.

In some examples, the one or more sensors 108 may include a sensor such as a rectifier, voltage divider, or analog-to-digital converter, to measure and monitor voltage. In some examples, a current transformer or analog-to-digital converter may be used to measure and monitor current. current transformers (CTs), Rogowski coils, or Hall effect sensors. For measuring leakage current on grounding conductors, sensors with milliamp-level sensitivity may be employed. For example, a current transformer with a sensitivity of approximately 0.1 V/A may be suitable for detecting the small leakage currents typically present on grounding conductors while also accommodating larger fault currents. For example, the current transformer may be configured to detect currents within a range of approximately 1 mA to 1 A. Alternative, in some examples, the current transformer may be configured to detect current within a range of approximately 1 mA to 10 A. In some cases, split-core current transformers may be used to facilitate installation on existing grounding conductors without requiring disconnection of the conductor.

As illustrated in FIG. 1, the smart monitor 110 may include a processor device 112 (or, generally "processor" 112), one or more analog-to-digital converters (ADCs) 114, a communications module 116, a memory 118, and a real-time clock (RTC) 120. In some examples, the processor device 112 may control a timing with which the one or more sensors 108 obtain readings. Moreover, readings obtained by the one or more sensors 108 may be stored in the memory 118 as historical measurement (e.g., historical electrical current) values for further processing by the smart monitor 110, as discussed below.

The processor device 112 can be any suitable hardware processor or combination of processors, including a central processing unit (CPU), a graphics processing unit (GPU), and so on. The processor device 112 may analyze signals from the one or more sensors 108 based on instructions stored in the memory 118. In some examples, the ADCs 114 may be utilized when analyzing the signals. For example, one or more current measurements may be accessed as analog signals by the ADCs 114 for conversion to digital values. In some examples, the signals from the one or more sensors 108 can be received from the memory 118 or other suitable data storage device or medium.

Moreover, the processor device 112 may then communicate processed signals to a remote interface 122 via the communications module 116. For example, the communications module 116 may transmit signals, and any corresponding status determinations, to the remote interface 122 via a wired or wireless connection. In some examples, the remote interface 122 is a display that can include any suitable display devices, such as a liquid crystal display (LCD) screen, a light-emitting diode (LED) display, an organic LED (OLED) display, an electrophoretic display, a computer monitor, a touchscreen, a television, and so on. In other examples, the remote interface 122 can be any suitable computing device or combination of devices, such as a laptop computer, a smartphone, a desktop computer, a tablet computer, a server computer, a virtual machine being executed by a physical computing device, a cloud resource, a set of GPUs, or the like.

As further illustrated in FIG. 1, the ground monitoring system 100 may include an optional communication connection 124 with other sensors, panels, ground locations, etc. For example, the communications module 116 may receive ground status determinations or sensor values from other ground monitoring systems. In some examples, the other ground monitoring systems may correspond to additional panels or sub-panels within the same facility, building, or location as the electrical panel 106.

With this arrangement, as further detailed below, electrical current values between the electrical panel and the earth ground 104 can be sampled by the corresponding sensor 108, to characterize leakage current from the electrical panel 106 to ground. Corresponding signals can then be provided to the smart monitor 110 and, based on these signals, the smart monitor 110 can determine whether an alert or other remedial action relating to grounding should be taken. For example, comparison between the sensed leakage current values and sensed power between the power source 102 and the electrical panel 106 (or other sensed system values) can indicate the likelihood that a grounding connection has been lost (e.g., become mechanically loose or detached).

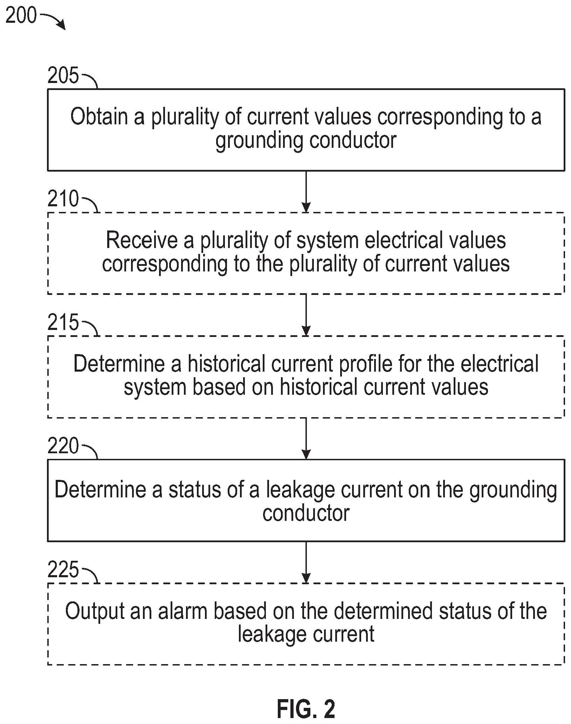

FIG. 2 is a flow diagram illustrating an example process 200 for monitoring a ground connection of an electrical system. As described below, a particular implementation can omit some or all illustrated features/steps, may be implemented in some examples in a different order, and may not require some illustrated features to implement all examples. In some examples, an apparatus (e.g., smart monitor 110) in connection with FIG. 1 can be used to perform all or part of example process 200. However, it should be appreciated that other suitable processing hardware for carrying out the operations or features described below may perform process 200.

At operation 205, a plurality of current values corresponding to a grounding conductor is obtained. In some examples, a sensor such as a clamp meter, an ammeter, a utility meter, or the like may be used to measure the plurality of current values. For example, as described above with respect to FIG. 1, the plurality of current values may be measured between the earth ground 104 and the electrical panel 106 using the one or more sensors 108. In some examples, the plurality of current values can include small leakage current values caused by the flow of current from loads or devices operating within a connected facility, building, or location.

At operation 210, the process 200 optionally receives a plurality of system electrical values corresponding to the plurality of current values for a grounding conductor (e.g., sensed leakage current from operation 205). For example, as described above with respect to FIG. 1, the plurality of power values may be measured between the power source 102 and the electrical panel 106 using the one or more sensors 108. In this regard, for example, a current sensor 108 can be used to monitor power input or consumption (e.g., assuming known input voltage), or other known sensors can be employed. For example, power values may be determined by measuring current on the phase conductors supplying the electrical panel 106 and multiplying by a known or measured voltage. For single-phase systems, power may be calculated as the product of voltage and current. For three-phase systems, power calculations may account for the phase relationships between conductors. In some cases, the smart monitor 110 may receive power values from a utility meter, a building energy management system, or other monitoring equipment via the communications module 116 (or otherwise). The power values may represent instantaneous power, average power over a sampling interval, or cumulative energy consumption.

At operation 215, the process 200 optionally determines a historical current profile for the electrical system based on historical current values. In some examples, the plurality of current values obtained at operation 205 may be analyzed, along with historical current values, alone or in combination with other system values from operation 210. For example, the historical current values may correspond to current values previously obtained over a given period of time, such as over a number of hours, days, months, years, seasons, etc., and thus can provide a temporal profile of leakage (or other) current over various time intervals. In some examples, a plurality of power values received at operation 210, or various historical power values, may be analyzed to determine the historical current profile. For example, historical values may indicate correlations between particular power usage and particular leakage current, or time-based relationships for or between power usage and leakage current. As described above with respect to FIG. 1, the pluralities of ground (e.g. leakage) current and system (e.g., power) values, as well as the historical current and power values may be saved and received from the memory 118.

In some examples, the historical current profile may characterize current behaviors and patterns for a given system. For example, the patterns may be a correlation between a time (e.g., time of day, block of time, etc.), an average leakage current observed, or an average power consumption. In some examples, a historical current profile may be automatically determined using a machine learning model or artificial intelligence. In other examples, a user may manually upload or enter a known current profile (e.g., by specifying a reference profile or reference time interval).

At operation 220, a status of a leakage current on the grounding conductor is determined. In some examples, the status may indicate that the earth ground is connected or disconnected from an electrical panel, or that there is an intermittent connection between the earth ground and the electrical panel. The status may be determined using the analyses performed and values received during operations 205 through 215, including as further detailed below.

In some examples the status may be determined based on whether or not there is noise (e.g., non-zero leakage current values) observed in the plurality of current values. For example, an absence of noise may indicate that the earth ground is disconnected. Similarly, in some cases, the presence of primarily noise as opposed to expected patterns may indicate that the earth ground is disconnected. For example, leakage current may be expected to generally track the generally step-like or staircase patterns of power usage for many monitored systems (e.g., building systems), so a grounding issue may be indicated by the presence of only noise in a sensed signal (e.g., with a corresponding absence of discernable pattern corresponding to present or historical usage).

In some examples, the threshold for distinguishing between noise and an absence of noise may be based on a baseline measurement for the monitored system. For example, a threshold falling in a range of approximately 1 mA to 100 mA may be used to distinguish between a connected state (where leakage current noise is present) and a disconnected state (where leakage current is substantially zero). In some cases, the threshold may be dynamically adjusted based on the historical current profile or the characteristics of the monitored electrical system. For example, a larger commercial or industrial facility may exhibit higher baseline leakage currents than a residential installation, and the threshold may be adjusted accordingly. In some examples, the processor may apply a noise floor filter to account for sensor noise or electromagnetic interference that may be present even when the grounding conductor is disconnected.

Moreover, in further examples, the plurality of power values and the plurality of current values on the grounding conductor may be compared. For example, at operation 220, the process 200 may determine if any spikes in current are proportional to increased power consumption by the system. Proportional current values and power values may indicate that the earth ground is connected to the electrical panel. Alternatively, if the values are not proportional, the status may indicate that the earth ground is disconnected from the electrical panel. For example, a disconnected state may be indicated when there is an absence of leakage current (i.e., the plurality of current values is stable or near-zero).

In some examples, the proportionality between leakage current and power consumption may be evaluated using a ratio or correlation coefficient. For example, a connected grounding system may exhibit a leakage current that is approximately 0.01% to 0.1% of the total load current (e.g., depending on the age and condition of the connected equipment and wiring). The processor may calculate a ratio of measured leakage current to measured load current and compare this ratio to expected values or historical ratios for the monitored system. A significant deviation from the expected ratio (e.g., a ratio approaching zero when power consumption is non-zero) may indicate a disconnected or degraded grounding connection.

Moreover, the process 200 may determine there is an intermittent connection between the earth ground and the electrical panel (e.g., due to a loose mechanical connection). For example, the values in the plurality of current values may alternate between having noise and having an absence of noise, or otherwise intermittently deviate from a reference profile or value, indicating corresponding transition of a grounding conductor between connected and disconnected states.

Furthermore, in some examples, the plurality of current values or the plurality of power values may be compared to the historical current profile to determine the status of the leakage current. For example, sensed current during monitoring of a grounding connection may be compared to historical leakage current for the grounding connection to identify potential disconnected states. Or, similarly, relationships between sensed current and other system values (e.g., power) may be compared with corresponding historical profiles to identify potential issues.

At operation 225, an alarm is optionally outputted based on the determined status of the leakage current, or other remedial action is optionally taken, as appropriate relative to the determined status from operation 220. In some examples, the alarm may be selected from a plurality of alarms. For example, one alarm may alert that the earth ground is disconnected from the electrical panel, and another alarm may indicate that an intermittent connection has been detected between the earth ground and the electrical panel. As described above with respect to FIG. 1, the alarm may be sent to a remote interface 122 via the smart monitor system 110. For example, the alarm may generate a notification on a personal cellular device or a remote server capable.

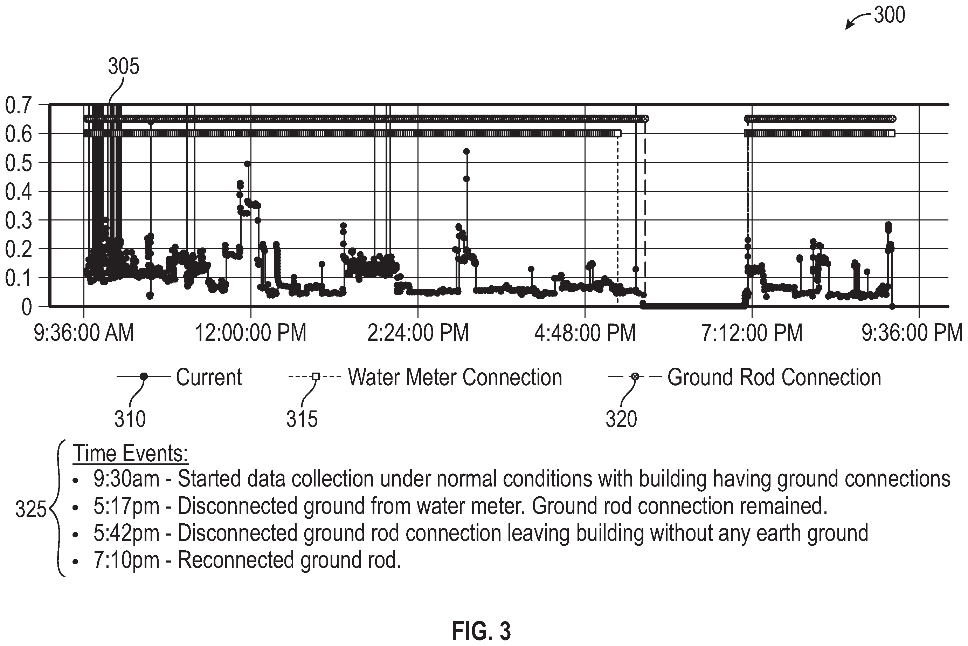

FIG. 3 is an example test data report 300 for monitoring a ground connection of an electrical system, according to the present disclosure. In particular, a current sensor (e.g., sensor 108) was connected to a ground connection (e.g., earth ground 104). The measurements taken by the current sensor are plotted in graph 305 as current measurements 310. The graph further illustrates water meter connection measurements 315 and ground rod connection measurements 320. Generally, the water meter connection may correspond to a variety of equipment bonded to ground during installation, such as a gas pipe, metal structural components of a building, or the like. In the illustrated example, the water meter connection may generally represent a backup grounding connection, with the ground rod connection representing a primary grounding connection for the monitored system. However, other configurations are possible. Similarly, the measured current can correspond to current along a grounding connection for any variety of systems (e.g., particular equipment, entire electrical systems of particular buildings, building electrical sub-systems, etc.).

In the graph 305, the current measurements 310, water meter connection measurements 315 and the ground rod connection measurements 320 are represented along a time trace, and in particular during the various conditions/events listed in time events list 325. Under the various approaches discussed above, the current measurements 310 may generally illustrate a secure ground connection when both the water meter connection measurements 315 and the ground rod connection measurements 320 have non-zero data values. For example, over this interval, non-zero noise in leakage current was detected, as shown by the non-zero data values of the current measurements 310. In some examples, the current measurements 310 may track a generally step-like or staircase pattern, as described above, which correspond to patterns of power usage within the monitored electrical system (e.g., due to regular or other on-off cycling of various powered devices sharing the common ground). In particular, a variety of step-like changes (e.g., each with corresponding noise) can be seen in the leakage current, corresponding to expected patterns of power consumption of the monitored system. Thus, for example, the system 100 may identify a secure grounding connection based on the leakage current represented by the initial current measurements 310.

In contrast, when the ground rod connection was disconnected at 5:42pm, the values of the current measurements 310 fell to a constant at zero, with a decreased amount of detected noise. Further, the disconnect resulted in a lack of steps or staircase patterns corresponding to expected usage (e.g., as based on historical measurements, as discussed above). Correspondingly, for example, the system 100 may identify a disconnected grounding connection and take appropriate action (e.g., send an alert). Further, in some examples, an intermittent fault corresponding to a loose grounding connection may be similarly identified based on detection of interspersed zero-noise (or step-less) and noisy (or step-like) profiles - e.g., with sensed current alternating regularly or irregularly between patterns similar to those before and after 5:42pm in the example of FIG. 3.

Thus, the disclosed ground monitoring technology can provide monitoring (e.g., continuously and automatically) of earth ground connections, thereby reducing the need for manual inspections to ensure that grounded connections remain operational. For example, through the monitoring of leakage current through a ground connection, potential disconnects or other issues can be efficiently identified, and alerts can be timely provided.

The use herein of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of' (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Unless otherwise specified or limited, the terms "about" and "approximately," as used herein with respect to a reference value, refer to variations from the reference value of ± 20% or less (e.g., ± 15, ± 10%, ± 5%, etc.), inclusive of the endpoints of the range. Similarly, as used herein with respect to a reference value, the term "substantially equal" (and the like) refers to variations from the reference value of less than ± 5% (e.g., ± 2%, ± 1%, ± 0.5%) inclusive. Where specified in particular, "substantially" can indicate a variation in one numerical direction relative to a reference value. For example, the term "substantially less" than a reference value (and the like) indicates a value that is reduced from the reference value by 30% or more (e.g., 35%, 40%, 50%, 65%, 80%), and the term "substantially more" than a reference value (and the like) indicates a value that is increased from the reference value by 30% or more (e.g., 35%, 40%, 50%, 65%, 80%).

As used herein, unless otherwise specified, ordinal numbers are used for convenience to differentiate between systems, components, etc. based on the order of introduction into the relevant text. Correspondingly, unless otherwise specified, ordinal numbers are not intended to indicate a particular sequential order, priority, or other limitation.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. One or more features of the devices and systems described may be incorporated into/used in corresponding methods and vice versa.

In some implementations, devices or systems disclosed herein can be utilized, manufactured, installed, etc. using methods embodying aspects of the disclosed technology. Correspondingly, unless otherwise indicated, any description herein of particular features, capabilities, or intended purposes of a device or system should be considered to disclose, as examples of the disclosed technology a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated, discussion herein of any method of manufacturing or using for a particular device or system, including installing the device or system, should be understood to disclose, as examples of the disclosed technology, the utilized features and implemented capabilities of such device or system.

The previous description of the disclosed examples is provided to enable any person skilled in the art to make or use the disclosed technology. Various modifications to these examples will be readily apparent to those skilled in the art, and the generic principles defined herein may be applied to other examples without departing from the spirit or scope of the disclosed technology. Thus, the disclosed technology is not intended to be limited to the examples shown herein but is to be accorded the widest scope consistent with the principles and novel features disclosed herein.

## Claims

1. A ground monitoring system for an electrical system, the ground monitoring system comprising:
a grounding conductor;
a current sensor electrically connected to the grounding conductor;
a processor in communication with the current sensor; and
a memory in communication with the processor and having instructions stored thereon that, when executed, cause the processor to:
measure, via the current sensor, a plurality of current values corresponding to a leakage current on the grounding conductor;
based on the plurality of measured current values, determine a status of leakage current on the grounding conductor; and
output a first alarm based upon the status of the leakage current.

2. The ground monitoring system of claim 1, wherein the status of leakage current on the grounding conductor is determined based on a determination of whether noise is present in the plurality of current values.

3. The ground monitoring system of either of claims 1 or 2, wherein the memory has further instructions stored thereon that, when executed, cause the processor to:
determine a historical current profile for the electrical system based on historical current values; and
as part of determining the status of the leakage current, compare the plurality of measured current values to the historical current profile.

4. The ground monitoring system of claim 3, wherein the memory has further instructions stored thereon that, when executed, cause the processor to:
identify one or more patterns in the historical current values, wherein the one or more patterns comprise a correlation between a time and an average leakage current.

5. The ground monitoring system of any one of claims 1-4, wherein the memory has further instructions stored thereon that, when executed, cause the processor to:
output a second alarm upon determining there is an intermittent presence of the leakage current on the grounding conductor.

6. The ground monitoring system of any one of claims 1-5, further comprising a surge protection module, wherein the current sensor is arranged within the surge protection module.

7. The ground monitoring system of any one of claim 1-6, wherein the memory has further instructions stored thereon that, when executed, cause the processor to:
receive a plurality of power values of the electrical system corresponding to the plurality of current values,
wherein determining the status of the leakage current comprises comparing the plurality of power values to the plurality of current values.

8. The ground monitoring system of claim 7, wherein comparing the plurality of power values to the plurality of current values comprises:
identifying one or more increases in the plurality of current values; and
determining the status based on determining if the one or more increases are proportional to increased power consumption indicated by the plurality of power values.

9. A method of monitoring a ground connection of an electrical system, the method comprising:
obtaining, via a sensor, a plurality of current values corresponding to a leakage current of a grounding conductor;
determining a status of leakage current of the grounding conductor based on the plurality of current values; and
outputting a first alarm based upon the status of the leakage current corresponding to a disconnected status or an intermittently connected status of the grounding conductor.

10. The method of claim 9, further comprising:
determining a historical current profile for the electrical system based on historical current values,
wherein determining a status of leakage current of the grounding conductor comprises comparing the plurality of current values to the historical current profile.

11. The method of claim 10, further comprising:
identifying one or more patterns in the plurality of current values; and
updating the historical current profile based on the one or more patterns.

12. The method of any one of claims 9-11, further comprising:
receiving a plurality of power values of the electrical system corresponding to the plurality of current values,
wherein determining a status of leakage current of the grounding conductor comprises comparing the plurality of power values to the plurality of current values.

13. The method of claim 12, wherein comparing the plurality of power values to the plurality of current values comprises:
identifying one or more increases in the plurality of current values; and
determining the status based on determining if the one or more increases are proportional to increased power consumption indicated by the plurality of power values.

14. The method of any one of claims 9-13, wherein the status of leakage current of the grounding conductor is determined based on a determination of whether noise is present in the plurality of current values.

15. The method of any one of claims 9-14, further comprising:
outputting a second alarm upon determining there is an intermittent presence of the leakage current on the grounding conductor.
